# EUROPÄISCHE PATENTSCHRIFT

(11) **EP 1 334 524 B1**
(45) Veröffentlichungstag und Bekanntmachung des Hinweises auf die Patenterteilung: **01.10.2014**
(21) Anmeldenummer: 01996891.6
(22) Anmeldetag: 14.11.2001
(51) Int. Cl.: H01L 33/20, H01L 33/38

(54) **LUMINESZENZDIODE MIT HOHER AUSKOPPELEFFIZIENZ**
LUMINESCENT DIODE WITH HIGH DECOUPLING EFFICIENCY
DIODE LUMINESCENTE A RENDEMENT DE COUPLAGE ELEVE

(30) Priorität: 14.11.2000 DE 10056292
(43) Veröffentlichungstag der Anmeldung: 13.08.2003
(73) Patentinhaber: OSRAM Opto Semiconductors GmbH, 93055 Regensburg (DE)
(72) Erfinder: WIRTH, Ralph, 93049 Regensburg (DE)
(74) Vertreter: Epping - Hermann - Fischer
(86) Internationale Anmeldenummer: PCT/DE2001/004264
(87) Internationale Veröffentlichungsnummer: WO 2002/041410

(56) Entgegenhaltungen:
- EP-A1- 0 544 512
- WO-A-01/61765
- DE-A- 4 218 806
- DE-A- 19 517 697
- DE-A- 19 709 228
- US-A- 5 744 828
- US-A- 5 753 940
- PATENT ABSTRACTS OF JAPAN vol. 016, no. 336 (E-1237), 21. Juli 1992 (1992-07-21) -& JP 04 100277 A (TOSHIBA CORP), 2. April 1992 (1992-04-02)
- PATENT ABSTRACTS OF JAPAN vol. 1996, no. 08, 30. August 1996 (1996-08-30) -& JP 08 111544 A (SHARP CORP), 30. April 1996 (1996-04-30)
- PATENT ABSTRACTS OF JAPAN vol. 010, no. 141 (E-406), 24. Mai 1986 (1986-05-24) & JP 61 005585 A (ROHM KK), 11. Januar 1986 (1986-01-11)

## Beschreibung

Die Erfindung betrifft eine Lumineszenzdiode mit einer Photonen emittierenden aktiven Schicht und einer zumindest für einen Teil der emittierten Photonen durchlässigen Fensterschicht, auf der mindestens ein Kontakt zur Stromeinspeisung in die aktive Schicht ausgebildet ist.

Eine derartige Lumineszenzdiode ist aus der US 52 33 204 A bekannt. Die bekannte Lumineszenzdiode weist einen Licht erzeugenden Bereich auf, der auf einem absorbierenden Substrat angeordnet ist. Oberhalb des Licht erzeugenden Bereichs ist eine Fensterschicht angeordnet, deren Dicke so gewählt ist, daß an einer Oberseite der Fensterschicht totalreflektierte Lichtstrahlen nicht zum Substrat gelenkt werden, sondern auf eine Seitenfläche der Fensterschicht treffen und dort aus der Fensterschicht austreten können. Die Fensterschicht hat darüber hinaus die Aufgabe, den über eine Kontaktstelle in die Fensterschicht eingespeisten Strom gleichmäßig über den aktiven Bereich hinweg zu verteilen.

Ein Nachteil der bekannten Lumineszenzdiode ist, daß unmittelbar unter der Kontaktstelle im aktiven Bereich erzeugtes Licht nicht ohne weiteres entweichen kann. Insbesondere die in Richtung auf die Kontaktstelle von dem aktiven Bereich ausgehenden Lichtstrahlen werden von der Kontaktstelle größtenteils in das absorbierende Substrat zurückreflektiert.

Es wurde daher in der EP 0 544 512 A vorgeschlagen, auf die Fensterschicht zu verzichten und statt dessen baumartige strukturierte Leiterbahnen auf der Oberfläche der Leuchtdiode vorzusehen. Die Besonderheit dabei ist, daß die Leiterbahnen bis auf die Spitzen der Leiterbahnzweige von der darunterliegenden Schicht elektrisch isoliert sind. Der Strom wird daher nur punktförmig in die darunterliegenden, Licht erzeugenden Schichten eingespeist. Diese Stellen sind jedoch gleichmäßig über die Oberfläche der Lumineszenzdiode hinweg verteilt. Zur Steigerung der Lichtausbeute wird ferner vorgeschlagen, in der Nähe der Licht emittierenden Punkte abgeschrägte Lichtaustrittsflächen vorzusehen, so daß das erzeugte Licht nach einer kurzen Wegstrecke in der Lumineszenzdiode aus dieser austreten kann. Die abgeschrägten Lichtaustrittsflächen werden durch eine mesaförmige Ausgestaltung der unter der Leiterbahn liegenden Schichten bewerkstelligt. Bei diesen Schichten handelt es sich um die zur Ausbildung einer doppelten Heterostruktur erforderlichen, dotierten Abdeckschichten, zwischen denen eine undotierte Licht emittierende Schicht angeordnet ist. Durch eine derartige Anordnung konnte die Lichtausbeute im Vergleich zum damaligen Stand der Technik um einen Faktor 1,5 gesteigert werden.

Die Druckschriften DE 42 18 806 A1, JP 61 005585 A, US 5 744 828 A, JP 08 111544 A und EP 0 544 512 A offenbaren jeweils Lumineszenzdioden, die einen Kontakt auf einer Lichtaustrittsfläche und sich vom Kontakt über die Lichtaustrittsfläche erstreckende Leiterbahnen aufweisen. Die Druckschrift US 5 753 940 A offenbart eine Lumineszenzdiode, die im Randbereich eine bis in die aktive Schicht hinein reichende Vertiefung aufweist.

Ausgehend von diesem Stand der Technik liegt der Erfindung die Aufgabe zugrunde, eine Lumineszenzdiode mit weiter verbesserter Lichtausbeute zu schaffen.

Diese Aufgabe wird erfindungsgemäß durch eine Lumineszenzdiode mit den Merkmalen des Patentanspruches 1 gelöst. Ein Merkmal der Lumineszenzdiode besteht darin, daß der Kontakt von einer Leiterbahn gebildet wird, die auf einer entlang der Leiterbahn langgestreckten Erhebung der Fensterschicht angeordnet ist. Die Fensterschicht weist einen langgestreckten umlaufenden Auskoppelrandsteg auf, auf dem eine langgestreckte entlang dem Rand der Lumineszenzdiode umlaufende Kontaktleitung ausgebildet ist. Der Auskoppelrandsteg weist mindestens eine längs zur Kontaktleitung verlaufende Seitenfläche auf, die mit Vorsprüngen profiliert ist, die sich quer zur Kontaktleitung erstrecken.

Durch die Ausbildung des Kontakts als Leiterbahn wird der Strom in die aktive Schicht nicht nur punktförmig, sondern über eine größere langestreckte Fläche in die aktive Schicht injiziert. Ein wesentlicher Teil der in der aktiven Schicht erzeugten Photonen können die Lumineszenzdiode über die Seitenfläche der Erhebung der Fensterschicht verlassen. Dies gilt auch für einen Großteil von solchen Photonen, deren Bahnen in der Fensterschicht nahezu längs der Leiterbahn und damit längs der Erstreckungsrichtung der Erhebung verlaufen und bei einer nicht profilierten Fensterschicht an deren äußeren Grenzfläche totalreflektiert werden würden. Denn durch die Profilierung der Seitenfläche mit sich quer zur Leiterbahn erstreckenden Vorsprüngen, treffen auch diese Photonen auf einen Abschnitt der Seitenfläche unter einem Winkel, der kleiner als der Winkel für die Totalreflexion ist. Daher gehen diese Photonen nicht verloren, sondern tragen zur Steigerung der Lichtausbeute bei. In einem Experiment ergab sich eine Erhöhung der Lichtausbeute gegenüber den aus dem Stand der Technik bekannten Lumineszenzdioden mit einfacher Fensterschicht etwa um den Faktor 2.

Bei einer bevorzugten Ausgestaltung der Erfindung sind die Vorsprünge pyramidenstumpfartig ausgebildet, bei denen die von deren Seitenflächen eingeschlossenen Winkel derart gewählt sind, dass in ihnen verlaufende Photonentrajektorien nach jedem Auftreffen auf die Flanken eines Vorsprunges in einem einen spitzeren Winkel auf die nachfolgend erreichte Flanke auftreffen, und zwar so oft bis der Grenzwinkel der Totalreflexion unterschritten wird und das Photon aus der Fensterschicht austritt.

Weitere vorteilhafte Ausgestaltungen sind Gegenstand der abhängigen Ansprüche.

Nachfolgend wird die Erfindung im einzelnen anhand der beigefügten Zeichnung erläutert. Es zeigen:
- Figur 1: eine schematische Darstellung einer perspektivischen Ansicht einer Lumineszenzdiode, die Leiterbahnzüge auf einer Fensterschicht mit sägezahnförmig profilierten Seitenflächen aufweist;
- Figur 2: eine schematische Darstellung einer vergrößerten Darstellung der Profilierung der Seitenflächen der Lumineszenzdiode aus Figur 1;
- Figur 3: eine schematische Darstellung einer Aufsicht auf die Lumineszenzdiode aus Figur 1;
- Figur 4: eine schematische Darstellung eines Querschnitts durch die Lumineszenzdiode aus Figur 3 entlang der Schnittlinie IV-IV;
- Figur 5: ein Diagramm, das die Lichterzeugung in der aktiven Schicht entlang der Schnittlinie IV-IV schematisch zeigt;
- Figur 6: eine schematische Darstellung eines Querschnitts durch eine herkömmliche Lumineszenzdiode mit einer auf einem Substrat aufgebrachten aktiven Schicht, auf der eine zusätzliche Fensterschicht angeordnet ist;
- Figur 7: ein Diagramm, das die Lichterzeugung in der aktiven Schicht über den Querschnitt aus Figur 6 hinweg schematisch zeigt;
- Figur 8: eine schematische Darstellung eines Querschnitts durch eine Lumineszenzdiode, deren aktive Schicht strukturiert ist und die eine zentrale Kontaktstelle aufweist;
- Figur 9: ein Diagramm, das die Lichterzeugung in der aktiven Schicht der Lumineszenzdiode aus Figur 8 schematisch darstellt;
- Figur 10: eine schematische Darstellung eines Querschnitts durch eine Lumineszenzdiode mit unstrukturierter Fensterschicht, deren Leiterbahnen entsprechend den Leiterbahnen der Leuchtdiode aus Figur 1 ausgebildet sind;
- Figur 11: ein Diagramm, das die Lichterzeugung in der aktiven Schicht der Lumineszenzdiode aus Figur 10 schematisch zeigt; und
- Figur 12: eine schematische Darstellung einer Aufsicht auf eine abgewandelte Form der Lumineszenzdiode gemäß der Erfindung.

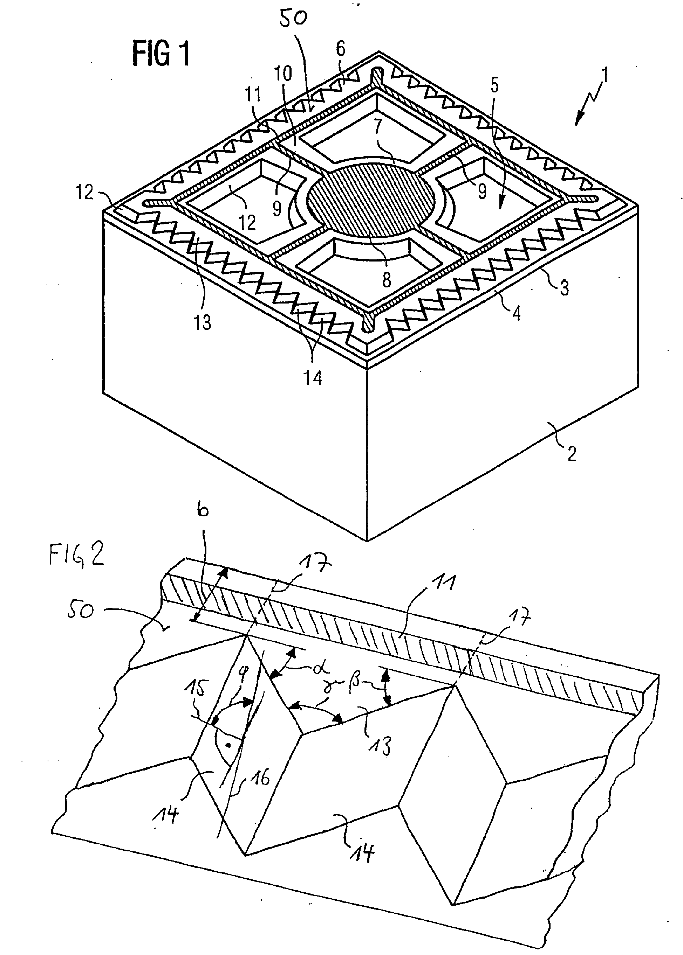

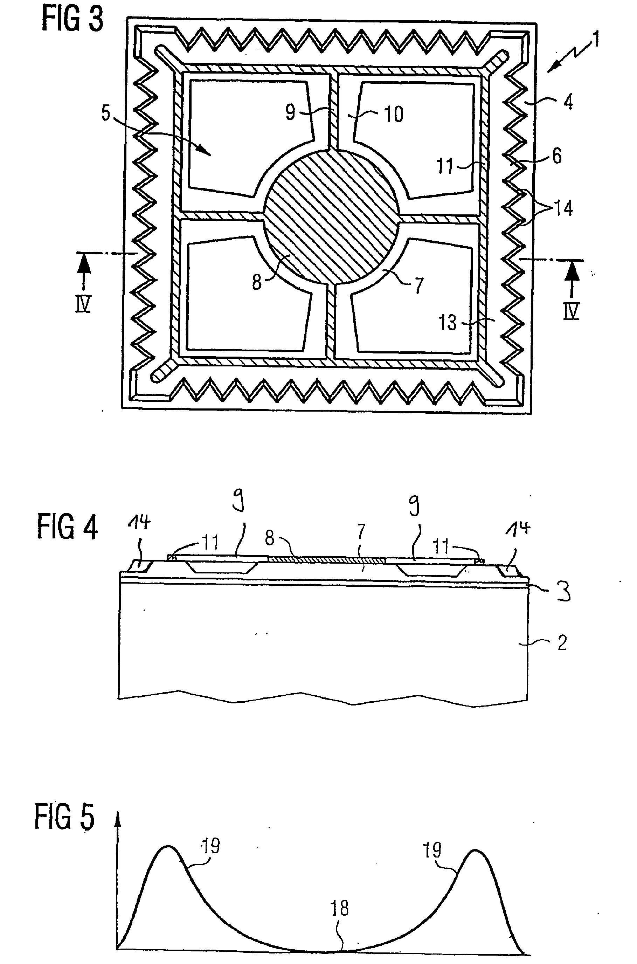

Die Lumineszenzdiode 1 der Figuren 1 und 3 weist ein Substrat 2 auf, auf dem eine photonenemittierende aktive Schicht 3 aufgebracht ist. Eine solche aktive Schicht 3 kann aus einer einzigen Schicht bestehen oder eine Schichtenfolge mit einer Mehrzahl von Einzelschichten sein.

Oberhalb der aktiven Schicht 3 befindet sich eine Fensterschicht 4, die auf einer Oberseite 5 eine Erhöhung in Form eines umlaufenden Randsteges 6, der hier einen Auskoppelsteg darstellt, aufweist. In der Mitte der Oberseite 5 befindet sich auf einer zentralen Erhöhung 7 eine Kontaktstelle 8, die gegenüber der Fensterschicht 4 elektrisch isoliert ist. Über Verbindungsleitungen 9, die zwischen der zentralen Erhöhung 7 und dem Randsteg 6 wiederum auf von Erhöhungen der Fensterschicht 4 gebildeten Verbindungsstegen 10 verlaufen, ist die Kontaktstelle 8 mit einer Randleitung 11, die sich auf dem Randsteg 6 befindet, verbunden. Auch die Verbindungsleitungen 9 sind gegenüber der Fensterschicht 4 elektrisch isoliert. Der Strom gelangt daher zumindest im Wesentlichen nur über die Randleitung 11 in die aktive Schicht 3.

Der Randsteg 6 weist eine die Oberseite 5 der Fensterschicht 4 mit der Oberseite 50 des Randsteges 6 verbindende Seitenfläche 12 auf, die sägezahnartig mit sich quer zur Erstrekkungsrichtung der Randleitung 11 erstreckenden Vorsprüngen 13 profiliert ist. Die Vorsprünge 13 sind pyramidenstumpfartig ausgebildet und weisen zumindest teilweise schräg zur Oberseite 5 stehende Flanken 14 auf.

In Figur 2 ist einer der Vorsprünge 13 vergrößert dargestellt. Die Neigung der Flanken 14 ist so gewählt, daß der Winkel ϕ zwischen einer Normalen 15 einer Flanke 14 und einer Normalen 16 der aktiven Schicht 3 kleiner 88° und größer 45° ist. Die Winkel α (= der von einer ersten Flanke des Vorsprungs 13 mit der Erstreckungsrichtung der Randleitung 11 eingeschlossene Winkel), β (= der von einer zweiten Flanke des Vorsprungs 13 mit der Erstreckungsrichtung der Randleitung 11 eingeschlossene Winkel), γ (= der von der ersten Flanke und der zweiten Flanke des Vorsprungs 13 eingeschlossene Winkel) sind vorzugsweise so gewählt, daß einer dieser Winkel kleiner 10° ist. Außerdem sollte keiner der Winkel gleich 45° oder gleich 60° sein, da in diesen hochsymmetrischen Fällen die Auskoppeleffizienz sinkt. Ferner ist es von Vorteil, wenn für das Verhältnis V der Breite b von Engstellen 17 des Randsteges 16 zu der Höhe des Randsteges 6 gilt: 0,1 < V < 10, vorzugsweise 1 < V < 3.

Figur 4 zeigt einen Querschnitt entlang der in Figur 3 eingezeichneten Schnittlinie IV-IV. Figur 5 zeigt die Lichterzeugungsrate entlang der Schnittlinie IV-IV. Unter Lichterzeugung ist dabei die Rate der in der aktiven Schicht 3 erzeugten Photonen zu verstehen, welche im wesentlichen die Stromdichte und damit die besonderen Eigenschaften der jeweiligen Strominjektion wiederspiegelt.

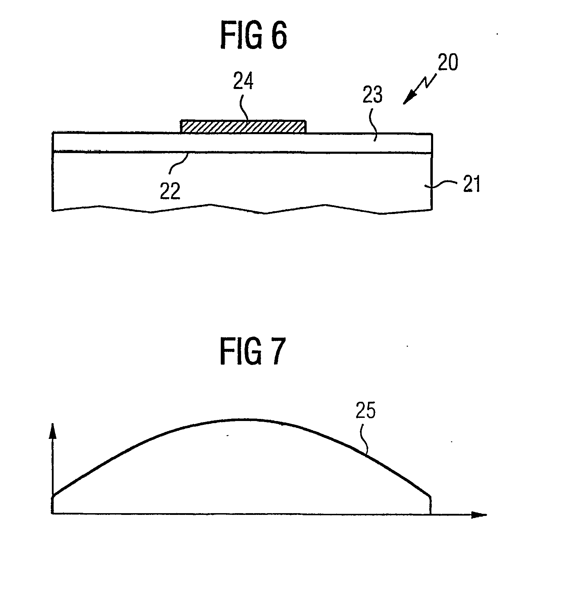

Man erkennt, daß die Lichterzeugungsrate unmittelbar unter der Kontaktstelle 8 verschwindend gering ist. Dementsprechend weist die Lichterzeugungsrate dort ein Minimum 18 auf. Im Bereich des Randsteges 6 weist die Lichterzeugungsrate jedoch Maxima 19 auf, da dort der Strom von der Randleitung 11, die im Gegensatz zu der Kontaktstelle 8 und den Verbindungsleitungen 9 nicht gegenüber der Fensterschicht elektrisch isoliert ist, in die Fensterschicht 4 injiziert wird. Für eine effiziente Lichtauskopplung ist von Bedeutung, daß sich der profilierte Randsteg 6 in unmittelbarer Nähe der Maxima 19 der Lichterzeugungsrate befinden. Denn die Kombination von lokaler Strominjektion und Strukturierung auf der Oberseite der Fensterschicht 4 führt zu einer hohen Lichtausbeute. Dies sei im folgenden anhand der in den Figuren 6 bis 11 dargestellten Vergleichsbeispiele näher erläutert.

Bei folgenden Untersuchungen wurde eine Grundfläche der Lumineszenzdioden von 300 Mikrometer x 300 Mikrometer und ein absorbierendes Substrat verwendet. Die Dicke der aktiven Schicht war 200 nm und ein Absorptionskoeffizient lag bei 10.000/cm. Die Dicke der Fensterschicht war 10 Mikrometer, die Reflektivität der Kontakte lag bei 30%, der Brechungsindex der aktiven Schicht war bei 3,2, im übrigen innerhalb des Halbleiterchips bei 3,5. Der Brechungsindex des umgebenden Mediums war bei 1,5.

### Vergleichsbeispiel 1:

Betrachtet sei die in Figur 6 dargestellte würfelförmige Lumineszenzdiode 20. Diese Lumineszenzdiode 20 weist ein Substrat 21 auf, auf dem eine aktive Schicht 22 ausgebildet ist, die von einer Fensterschicht 23 abgedeckt ist. Auf der Fensterschicht 23 befindet sich ferner eine zentrale Kontaktstelle 24, die gegenüber der Fensterschicht 23 nicht elektrisch isoliert ist. Bei einer solchen Lumineszenzdiode ergibt sich die in Figur 7 dargestellte Verteilungskurve 25 der Lichterzeugungsrate.

Ein Vergleich der Figuren 6 und 7 zeigt, daß die maximale Lichterzeugung unmittelbar unter der zentralen Kontaktstelle 24 stattfindet. Ein Großteil der dort erzeugten Photonen wird jedoch entweder unmittelbar an der Grenzfläche zur Kontaktstelle 24 absorbiert oder von der Kontaktstelle 24 in das absorbierende Substrat 21 zurückreflektiert. Dementsprechend werden bei dieser Lumineszenzdiode 20 nur etwa 5% der erzeugten Photonen aus der Lumineszenzdiode 20 ausgekoppelt. Das Verhältnis von austretenden Photonen zu der Zahl der erzeugten Photonen wird nachfolgend kurz als Auskoppeleffizienz bezeichnet. Im folgenden wird zum relativen Vergleich die Effizienz der Lumineszenzdiode 20 auf 100% gesetzt.

### Vergleichsbeispiel 2:

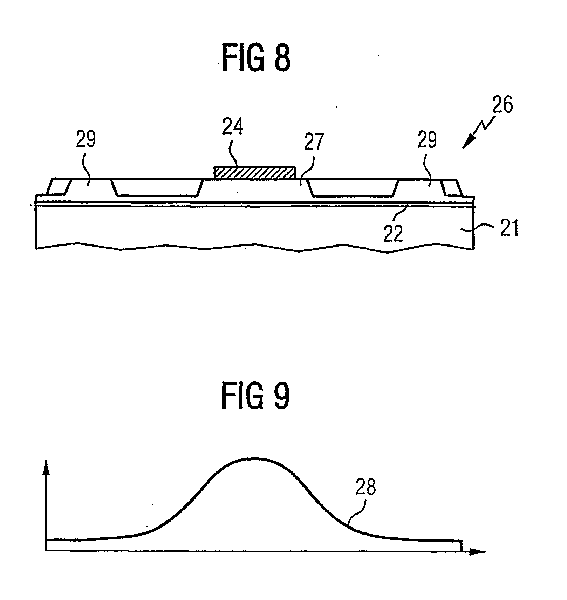

In Figur 8 ist der Querschnitt einer weiteren Lumineszenzdiode 26 dargestellt, deren Fensterschicht 27 entsprechend der Fensterschicht 4 der Lumineszenzdiode 1 strukturiert ist. Auch bei der Lumineszenzdiode 26 erfolgt die Strominjektion in die aktive Schicht 22 über die zentrale Kontaktstelle 24.

Dadurch ergibt sich die in Figur 9 dargestellte unter der Kontaktstelle 24 konzentrierte Verteilung 28 der Lichterzeugungsrate.

Die Lichterzeugung findet auch bei dieser Lumineszenzdiode 26 hauptsächlich unmittelbar unter der Kontaktstelle 24 statt. Auf die Auskoppeleffizienz der Lumineszenzdiode 20 bezogen, weist die Lumineszenzdiode 26 eine um 50% erhöhte Auskoppeleffizienz, das heißt 150% auf. Dies ist für sich genommen bereits bemerkenswert, da auch bei der Verteilungskurve 25 die Lichterzeugung keinesfalls unmittelbar unter dem Randsteg 29 konzentriert ist, der dem Randsteg 6 der Lumineszenzdiode 1 entspricht. Diese Untersuchung belegt daher bereits die vorteilhafte Wirkung eines am Rand der Lumineszenzdiode 1 vorgesehenen, sägezahnförmig profilierten Randsteges 6.

### Vergleichsbeispiel 3:

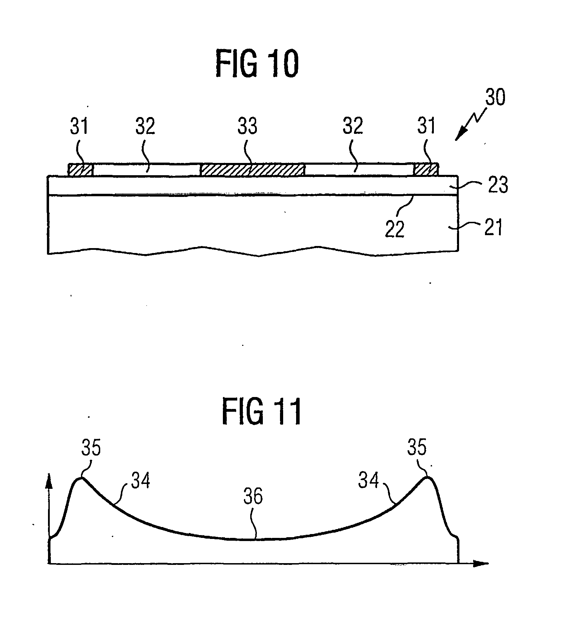

Hierbei wurde, wie in Figur 10 dargestellt, eine Lumineszenzdiode 30 verwendet, bei der eine Fensterschicht 23, wie bei der Lumineszenzdiode 20, unstrukturiert ist. Die Lumineszenzdiode 30 verfügt jedoch über eine Randleitung 31 und Verbindungsleitungen 32 sowie über eine zentrale Kontaktstelle 33, die genauso wie die Randleitungen 11, die Verbindungsleitungen 9 und die Kontaktstelle 8 der Lumineszenzdiode 1 ausgebildet sind. Insbesondere sind die Kontaktstelle 33 und die Verbindungsleitungen 32 von der Fensterschicht 23 elektrisch isoliert.

Damit ergibt sich die in Figur 11 dargestellte Verteilungskurve 34 der Lichterzeugungsrate, die unter der Randleitung 33 ein Maximum 35 aufweist. Aufgrund der Stromaufweitungsfunktion der Fensterschicht 23 fließt dennoch ein Teil des in die aktive Schicht 22 injizierten Stroms in den Bereich unterhalb der zentralen Kontaktstelle 33. Daher findet auch im Minimum 36 der Verteilungskurve 34 noch Lichterzeugung statt. Auf die Auskoppeleffizienz der Lumineszenzdiode 20 bezogen, weist die Lumineszenzdiode 30 eine um 40% erhöhte Auskoppeleffizienz, das heißt 140% auf.

### Ausführungsbeispiel:

Die Untersuchung für das anhand der Figuren 1 bis 4 beschriebene Ausführungsbeispiel ergab folgendes:
Durch den Randsteg 6 wird die Lichterzeugung zusätzlich konzentriert, so daß die Lichterzeugungsrate im Minimum nahezu auf Null zurückgeht. Außerdem befindet sich der profilierte Randsteg 6 unmittelbar in der Nähe der Maxima 19 der Lichterzeugungsrate, so daß das erzeugte Licht zu einem großen Teil nach sehr kurzen Weglängen im Chip ausgekoppelt wird.
Für die Lumineszenzdiode 1 ergab die Untersuchung eine auf die Auskoppeleffizienz der Lumineszenzdiode 20 bezogene Erhöhung der Auskoppeleffizienz von 175%, als eine Auskoppeleffizienz von 275%. Es zeigt sich also, daß die gezielte Injektion des Stromes unter dem profilierten Randsteg 6 ein Gewinn an Auskoppeleffizienz zur Folge hat, der weit über denjenigen Gewinn hinausgeht, der aus der Kombination der Einzelmaßnahmen zu erwarten wäre.

Zu dem hohen Gewinn an Auskoppeleffizienz trägt auch die pyramidenstumpfartige Ausgestaltung der Vorsprünge 13 bei. Durch die genannte Wahl der Winkel α, β und γ wird der Einfallswinkel der Photonen mit jeder Reflexion an einer Flanke kleiner und unterschreitet schließlich den Grenzwinkel für die Totalreflexion, so daß die Photonen aus der Lumineszenzdiode 1 austreten können. Darüber hinaus gewährleistet der Neigungswinkel der Flanken 14, daß die zunächst von der aktiven Schicht 3 nach oben verlaufenden Photonen mit jeder Reflexion flacher verlaufen, so daß sie schließlich seitlich aus den Randstegen 6 austreten können.

Es sei angemerkt, daß es sich bei den Vorsprüngen 13 auch um Prismen mit dreieckiger Grundfläche handeln kann, wenn sich die Randstege bis in die aktive Zone erstrecken.

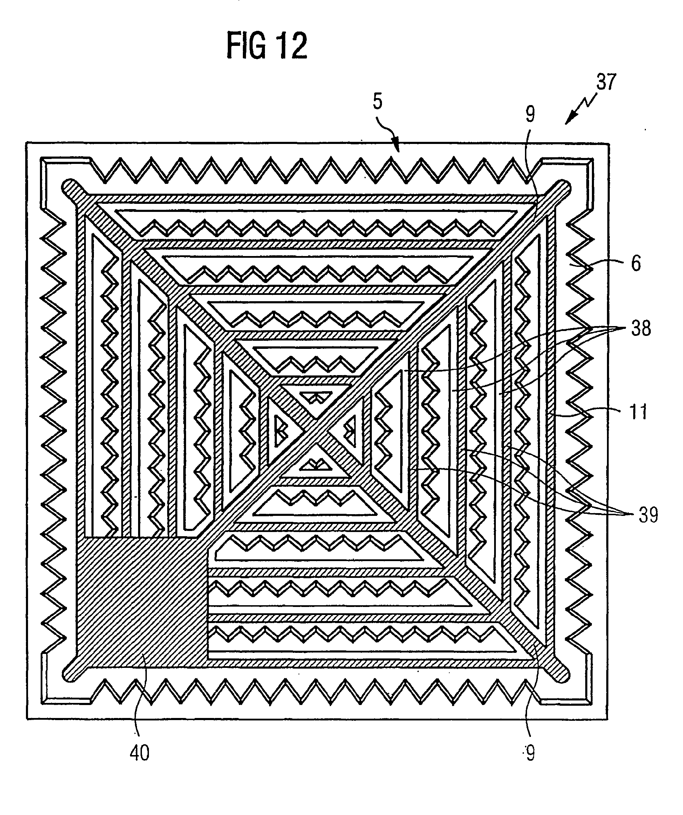

In Figur 12 ist schließlich ein weiteres Ausführungsbeispiel einer Lumineszenzdiode 37 dargestellt, die zusätzlich zum Randsteg 6 weitere Auskoppelstege in Form von Zwischenstegen 38 aufweist, die jeweils mit Vorsprüngen 13 profiliert sind, und auf denen Zwischenleitungen 39 verlaufen. Außerdem befindet sich bei dieser Lumineszenzdiode 37 eine Kontaktstelle 40 nicht mittig auf, sondern am Rand der Lumineszenzdiode 37. Abschließend sei als besonderer Vorteil der Lumineszenzdioden 1 und 30 hervorgehoben, daß deren flächenmäßige Ausdehnung nahezu beliebig groß gewählt werden kann, da eine Vergrößerung der flächenmäßigen Ausdehnung keine entsprechende Skalierung der Schichtdicke der Fensterschicht 4 erzwingt. Dieser Vorteil der Erfindung hält die Herstellung von großflächigen Chips mit Fensterschicht hinsichtlich des technischen Aufwandes in einem vertretbaren Rahmen.

Die erfindungsgemäßen Strukturen einer Lumineszenzdiode, insbesondere die oben beschriebenen Ausführungsbeispiele, eignen sich vorzugsweise für Lumineszenzdiodenstrukturen mit einer strahlungsemittierenden Schicht auf der Basis von GaP, wie InGaP, InGaAlP, GaAlP und GaP selbst, insbesondere mit einer strahlungsemittierenden Schicht, die eine aktive Zone auf der Basis von GaP, wie InGaP, InGaAlP, GaAlP und GaP aufweist. Derartige Lumineszenzstrukturen sind bekannt und werden von daher an dieser Stelle nicht näher erläutert.

## Patentansprüche

1. Lumineszenzdiode mit einer Photonen emittierenden aktiven Schicht (3) und einer zumindest für einen Teil der emittierten Photonen transparenten Fensterschicht (4), die mit Vorsprüngen (13) profiliert ist, und auf der ein elektrischer Kontakt (8, 9, 11) zur Stromeinspeisung in die aktive Schicht (3) ausgebildet ist,
**dadurch gekennzeichnet, daß** die Fensterschicht (4) einen langgestreckten umlaufenden Auskoppelrandsteg (6) aufweist, auf dem eine langgestreckte entlang dem Rand der Lumineszenzdiode umlaufende Kontaktleitung (11) ausgebildet ist, und der Auskoppelrandsteg (6) mindestens eine längs zur Kontaktleitung (11) verlaufende Seitenfläche (12) aufweist, die mit den Vorsprüngen (13) profiliert ist, die sich quer zur Kontaktleitung (11) erstrecken.

2. Lumineszenzdiode nach Anspruch 1,
**dadurch gekennzeichnet, daß** die Vorsprünge (13) spitz zulaufen.

3. Lumineszenzdiode nach Anspruch 1 oder 2,
**dadurch gekennzeichnet, daß** die Vorsprünge (13) eine dreieckige Grundfläche aufweisen.

4. Lumineszenzdiode nach einem der Ansprüche 1 bis 3,
**dadurch gekennzeichnet, daß** die Vorsprünge (13) ein sägezahnartiges Profil an der Seitenfläche (12) ausbilden.

5. Lumineszenzdiode nach einem der Ansprüche 1 bis 4,
**dadurch gekennzeichnet, daß** ein Scheitelwinkel γ der spitz zulaufenden Vorsprünge (13) in der Spitze kleiner 10° ist.

6. Lumineszenzdiode nach einem der Ansprüche 1 bis 5,
**dadurch gekennzeichnet, daß** der Winkel zwischen einer Flächennormalen (15) der zumindest teilweise die Seitenfläche (12) bildenden Flanken (14) der Vorsprünge (13) zu einer Flächennormalen (16) der aktiven Schicht (3) zwischen 45° und 88° liegt.

7. Lumineszenzdiode nach einem der Ansprüche 1 bis 4,
**dadurch gekennzeichnet, daß** sich die Seitenfläche (12) in die aktive Schicht (3) hinein fortsetzt.

8. Lumineszenzdiode nach Anspruch 7,
**dadurch gekennzeichnet, daß** die Vorsprünge (13) prismenartig ausgebildet sind.

9. Lumineszenzdiode nach einem der Ansprüche 1 bis 8,
**dadurch gekennzeichnet, daß** das Verhältnis von Höhe zu Breite einer Engstelle (17) des profilierten Auskoppelrandstegs (6) der Fensterschicht (4) größer 0,1 und kleiner 10 ist.

10. Lumineszenzdiode nach Anspruch 9,
**dadurch gekennzeichnet, daß** das Verhältnis zwischen einschließlich 1 und einschließlich 3 liegt.

11. Lumineszenzdiode nach einem der vorhergehenden Ansprüche,
**dadurch gekennzeichnet, daß**
die Kontaktleitung (11) durch mindestens eine gegenüber der Fensterschicht (4) elektrisch isolierte Verbindungsleitung (9) mit einer Kontakstelle (8) verbunden ist.

12. Lumineszenzdiode nach Anspruch 11,
**dadurch gekennzeichnet, daß** die Kontaktstelle (8) gegenüber der Fensterschicht (4) elektrisch isoliert ist.

13. Lumineszenzdiode nach einem der vorangehenden Ansprüche,
**dadurch gekennzeichnet, daß** der Auskoppelrandsteg (6) von einer Erhöhung der Fensterschicht (4) gebildet ist.

## Claims

1. Luminescence diode comprising a photon-emitting active layer (3) and a window layer (4), which is transparent at least to some of the emitted photons and which is profiled with projections (13) and on which an electrical contact (8, 9, 11) for feeding current into the active layer (3) is formed,
**characterized in that**
the window layer (4) has an elongated circumferentially extending coupling-out edge web (6), on which an elongated contact line (11) extending circumferentially along the edge of the luminescence diode is formed, and the coupling-out edge web (6) has at least one side surface (12) which runs longitudinally with respect to the contact line (11) and which is profiled with the projections (13) extending transversely with respect to the contact line (11).

2. Luminescence diode according to Claim 1,
**characterized in that**
the projections (13) taper to a point.

3. Luminescence diode according to Claim 1 or 2,
**characterized in that**
the projections (13) have a triangular base surface.

4. Luminescence diode according to any of Claims 1 to 3,
**characterized in that**
the projections (13) form a sawtooth-like profile at the side surface (12) .

5. Luminescence diode according to any of Claims 1 to 4,
**characterized in that**
a vertex angle γ of the projections (13) which taper to a point is less than 10° at the point.

6. Luminescence diode according to any of Claims 1 to 5,
**characterized in that**
the angle between a surface normal (15) of the flanks (14) of the projections (13), said flanks at least partly forming the side surface (12), and a surface normal (16) of the active layer (3) is between 45° and 88°.

7. Luminescence diode according to any of Claims 1 to 4,
**characterized in that**
the side surface (12) continues into the active layer (3) .

8. Luminescence diode according to Claim 7,
**characterized in that**
the projections (13) are embodied in a prism-like fashion.

9. Luminescence diode according to any of Claims 1 to 8,
**characterized in that**
the ratio of height to width of a narrow location (17) of the profiled coupling-out edge web (6) of the window layer (4) is greater than 0.1 and less than 10.

10. Luminescence diode according to Claim 9,
**characterized in that**
the ratio is between 1 and 3 inclusive.

11. Luminescence diode according to any of the preceding claims,
**characterized in that**
the contact line (11) is connected to a contact location (8) by at least one connecting line (9) which is electrically insulated from the window layer (4).

12. Luminescence diode according to Claim 11,
**characterized in that**
the contact location (8) is electrically insulated from the window layer (4).

13. Luminescence diode according to any of the preceding claims,
**characterized in that**
the coupling-out edge web (6) is formed by an elevation of the window layer (4).

## Revendications

1. Diode luminescente comprenant une couche active (3) émettant des photons et une couche fenêtre (4) au moins transparente pour une partie des photons émis, laquelle est profilée avec des saillies (13) et sur laquelle est réalisé un contact électrique (8, 9, 11) pour l'injection de courant dans la couche active (3),
**caractérisée en ce que**
la couche fenêtre (4) présente une nervure de bord de découplage (6) périphérique longiligne sur laquelle est réalisée une ligne de contact (11) périphérique allongée le long du bord de la diode luminescente, et la nervure de bord de découplage (6) présente au moins une face latérale (12) s'étendant longitudinalement par rapport à la ligne de contact (11), laquelle est profilée avec les saillies (13) qui s'étendent transversalement par rapport à la ligne de contact (11).

2. Diode luminescente selon la revendication 1,
**caractérisée en ce que**
les saillies (13) se terminent en pointe.

3. Diode luminescente selon la revendication 1 ou 2,
**caractérisée en ce que**
les saillies (13) présentent une face de base triangulaire.

4. Diode luminescente selon l'une quelconque des revendications 1 à 3,
**caractérisée en ce que**
les saillies (13) constituent un profil de type en dents de scie sur la face latérale (12).

5. Diode luminescente selon l'une quelconque des revendications 1 à 4,
**caractérisée en ce**
**qu'**un angle au sommet γ des saillies (13) se terminant en pointe est inférieur à 10° au niveau de la pointe.

6. Diode luminescente selon l'une quelconque des revendications 1 à 5,
**caractérisée en ce que**
l'angle entre une normale à la surface (15) des flancs (14) des saillies (13) formant au moins en partie la face latérale (12) et une normale à la surface (16) de la couche active (3) est compris entre 45° et 88°.

7. Diode luminescente selon l'une quelconque des revendications 1 à 4,
**caractérisée en ce que**
la face latérale (12) se prolonge dans la couche active (3).

8. Diode luminescente selon la revendication 7,
**caractérisée en ce que**
les saillies (13) sont réalisées sous forme prismatique.

9. Diode luminescente selon l'une quelconque des revendications 1 à 8,
**caractérisée en ce que**
le rapport de la hauteur à la largeur d'un point d'étranglement (17) de la nervure de bord de découplage (6) profilée de la couche fenêtre (4) est supérieur à 0,1 et inférieur à 10.

10. Diode luminescente selon la revendication 9,
**caractérisée en ce que**
le rapport est compris entre 1 inclusif et 3 inclusif.

11. Diode luminescente selon l'une quelconque des revendications précédentes,
**caractérisée en ce que**
la ligne de contact (11) est connectée par au moins une ligne de connexion isolée électriquement (9) par rapport à la couche fenêtre (4) à un point de contact (8).

12. Diode luminescente selon la revendication 11,
**caractérisée en ce que**
le point de contact (8) est isolé électriquement par rapport à la couche fenêtre (4).

13. Diode luminescente selon l'une quelconque des revendications précédentes,
**caractérisée en ce que**
la nervure de bord de découplage (6) est formée par un rehaussement de la couche fenêtre (4).
